# EUROPÄISCHE PATENTSCHRIFT

(11) **EP 2 502 273 B1**
(45) Veröffentlichungstag und Bekanntmachung des Hinweises auf die Patenterteilung: **05.06.2019**
(21) Anmeldenummer: 10779722.7
(22) Anmeldetag: 18.11.2010
(51) Int. Cl.: H01L 27/32

(54) **VERFAHREN ZUR HERSTELLUNG VON STRUKTURIERTEN ORGANISCHEN LEUCHTDIODEN UND DEREN VERWENDUNG**
METHOD FOR PRODUCING STRUCTURED ORGANIC LIGHT-EMITTING DIODES AND USE THEREOF
PROCÉDÉ DE FABRICATION DE DIODES ÉLECTROLUMINESCENTES ORGANIQUES STRUCTURÉES, ET LEUR UTILISATION

(30) Priorität: 19.11.2009 DE 102009053955
(43) Veröffentlichungstag der Anmeldung: 26.09.2012
(73) Patentinhaber: Fraunhofer-Gesellschaft zur Förderung der angewandten Forschung e.V., 80686 München (DE)
(72) Erfinder: KREISSL, Stefanie, 14715 Milower Land OT Jerchel (DE); FISCHER, Bert, 14974 Luckenwalde OT Ahrensdorf (DE); WEDEL, Armin, 14513 Teltow (DE)
(74) Vertreter: Pfenning, Meinig & Partner mbB
(86) Internationale Anmeldenummer: PCT/EP2010/007018
(87) Internationale Veröffentlichungsnummer: WO 2011/060939

(56) Entgegenhaltungen:
- EP-A2- 1 052 708
- WO-A2-2004/013920
- US-A- 5 949 186
- US-A1- 2001 001 485

## Beschreibung

Die Erfindung betrifft ein Verfahren zur Herstellung von strukturierten organischen Leuchtdioden, bei dem auf einem mit Indium-Zinn-Oxid beschichteten Träger eine Lochinjektionsschicht, eine Emitterschicht sowie eine Kathode abgeschieden wird, wobei die Lochinjektionsschicht und die Emitterschicht strukturiert abgeschieden werden. Die vorliegende Erfindung kann auf dem Gebiet von neuen, unter elektrischer Anregung selbstleuchtenden Sicherheitsbauelementen eingesetzt werden. Die vorliegende Erfindung wird zur Anzeige von Strukturen innerhalb einer flächig leuchtenden organischen Leuchtdiode genutzt und zum Nachweis und zur Kontrolle von Produkten eingesetzt. Die Erfindung betrifft ebenso eine derartig hergestellte organische Leuchtdiode.

Im einfachsten Aufbau besteht eine OLED (organische Leuchtdiode, engl. organic light emitting diode) aus einer Polymerschicht (Burroughes, J. H., Bradley, D. D. C., Brown, A. R., Marks, R. N., Mackay, K., Friend, R. H., Burns, P. L. und Holmes, A. B., Nature 347 (1990) 539) oder einer Schicht aufgebaut aus niedermolekularen Bausteinen (Tang, C. W. und van Slyke, 5. A., Appl. Phys. Lett. 51 (1987) 12, 913), welche sich zwischen zwei elektrischen Kontakten befindet. Davon wird der eine Kontakt transparent gewählt (ITO), für den anderen wird ein Metall mit geringer Austrittsarbeit für Elektronen eingesetzt (Aluminium, Kalzium, oder Magnesium/Silber) (Gu, G., Bulovic, V., Burrows, P. E. und Forrest, S. R., Appl. Phys. Lett. 68 (1996) 19, 2606). Die niedermolekularen Bausteine werden häufig aufgedampft, die Polymere aus der Lösung verarbeitet, z.B. durch spin-coating oder durch Ink-Jet Druck aufgebracht. Zusätzlich sind Lochinjektionsschichten (z.B. PEDOT:PSS) notwendig, die die Performance der OLED erhöhen. Diese werden im Allgemeinen aus einer wässrig-alkoholischen Lösung direkt auf die ITO-Schicht aufgebracht. Die Aufgabe besteht bei diesen Prozessen darin, die Schichten sehr dünn (ca. 100 nm), möglichst homogen und uniform aufzutragen, damit die späteren Leuchtflächen möglichst eine gleichmäßige Abstrahlung aufweist.

Die Abstrahlung der Anzeige beruht auf der Reflexion des Lichtes an der Metallelektrode. Das Licht wird dann durch die transparente ITO-Elektrode emittiert. Bedingt durch diese Konstruktion ist die Gesamtanordnung durch die reflektierende Metallelektrode nicht transparent und zeigt im Allgemeinen eine homogene gleichmäßige Abstrahlung.

WO 2004/013920 offenbart eine OLED mit einer strukturierten Passivierungsschicht auf einer Lochinjektionsschicht. In US 2001/001485 weist die Emitterschicht einer OLED einen homogenen und einen strukturierten Teil auf. In der OLED in US 5949186 wird eine strukturierte Ladungsträgerinjektions- oder blockierschicht verwendet um ein Standbild zu erzeugen. EP 1052708 offenbart eine OLED mit strukturierten Lochinjektions- und Emitterschicthen. Ausgehend hiervon war es Aufgabe der vorliegenden Erfindung, eine Strukturierung von organischen Leuchtdioden zu ermöglichen, so dass die Anzeige von Strukturen innerhalb einer flächig leuchtenden organischen Leuchtdiode ermöglicht wird.

Diese Aufgabe wird durch das Verfahren zur Herstellung strukturierter organischer Leuchtdioden mit den Merkmalen des Anspruchs 1 gelöst. Die weiteren abhängigen Ansprüche zeigen vorteilhafte Weiterbildungen auf. Erfindungsgemäß wird ein Verfahren zur Herstellung einer strukturierten organischen Leuchtdiode (OLED) bereitgestellt, bei dem
a) in einem ersten Schritt auf einem mit Indium-Zinnoxid beschichteten Träger eine Lochinjektionsschicht abgeschieden abgeschieden wird,
b) die Abscheidung mindestens einer Emitterschicht und einer Kathode erfolgt und
c) anschließend die OLED verkapselt wird.

Das erfindungsgemäße Verfahren zeichnet sich besonders dadurch aus, dass die Lochinjektionsschicht und die Emitterschicht strukturiert abgeschieden werden.

Gegenüber den aus dem Stand der Technik bekannten Herstellungsverfahren für organische Leuchtdioden weisen die erfindungsgemäß hergestellten organischen Leuchtdioden die folgenden Vorteile auf:
- Die Struktur des leuchtenden Sicherheitselementes lässt sich in beliebiger Art und Weise durch Ink-Jet-Druck erzeugen. Das Sicherheitselement kann durch ein beliebiges CAD-Programm erzeugt und zum Ink-Jet-Drucker übertragen werden.
- Das Layout kann jederzeit problemlos geändert werden, ohne dass eine Neustrukturierung des Substrates nötig ist.
- Die eingeschriebene Information im OLED-Element ist im ausgeschalteten Zustand nicht sichtbar.
- Der Kontrast des Sicherheitsmerkmals zur leuchtenden Fläche kann eingestellt werden.
- Die elektrische und optische OLED-Charakteristik wird durch die zum Leuchten gebrachte Struktur nicht verändert.
- Die einzuschreibenden Strukturen lassen sich mit hoher Zuverlässigkeit und Reproduzierbarkeit erzeugen.
- Das Sicherheitsmerkmal kann nicht ohne Zerstörung des Gesamtaufbaus verändert werden.
- Der technische Aufwand gegenüber Matrixdisplays ist wesentlich geringer.
- Aufgrund der hohen apparativen Anforderungen und des hohen erforderlichen Know-hows wird eine kaum zu überwindende Barriere für Fälscher geschaffen.

Erfindungsgemäss wird die Lochinjektionsschicht in zwei Schritten aufgebracht. Der erste Abscheideschritt erfolgt flächig und homogen, während der zweite Schritt eine strukturierte Abscheidung mittels Ink-Jet-Druck vorsieht. Die Abscheidung der homogenen Lochinjektionsschicht erfolgt vorzugsweise mittels Spin-Coating oder Ink-Jet-Druck. Weiterhin ist es vorgesehen, dass bei der Abscheidung der Emitterschicht in einem ersten Schritt auf der abgeschiedenen Lochinjektionsschicht, d.h. auf der homogenen oder strukturierten Lochinjektionsschicht, oder auf der Passivierungsschicht eine homogene Emitterschicht abgeschieden wird. Dies erfolgt mittels Spin-Coating oder Ink-Jet-Druck. In einem zweiten Schritt erfolgt dann die Abscheidung einer strukturierten Emitterschicht auf der homogenen Emitterschicht mittels Ink-Jet-Druck.

Erfindungsgemäss wird der Kontrast der Struktur der hergestellten organischen Leuchtdiode über das Verhältnis der abgeschiedenen Mengen für die homogenen und die strukturierten Schichten eingestellt.

Zwischen den Abscheideschritten werden die abgeschiedenen Schichten vorzugsweise getrocknet, insbesondere bei Temperaturen im Bereich von 80 bis 180°C.

Die Lochinjektionsschichten enthalten als Lochinjektionsmaterial vorzugsweise aus den Gruppen der wässrigen Dispersionen von Poly(3,4-ethylendioxythiophen)poly(styrensulfonat), Poly(thiophen-3-(2-(2-methoxyethoxy)ethoxy)-2,5-diyl (sulfoniert) oder Polyanilin.

Das Lochinjektionsmaterial wird vorzugsweise aus einem wässrigen Lösungsmittelgemisch abgeschieden. Besonders bevorzugt wird hier eine Mischung aus Wasser, Isopropanol, Ethylenglykol und einem Haftvermittler verwendet.

Die Emitterschicht enthält als Emitter vorzugsweise einen Singulettemitter, insbesondere ein konjugiertes Polymer ausgewählt aus der Gruppe bestehend aus substituierten Poly-(p-arylenvinylen)-Derivaten, Polyfluorenen, Polycarbazolen, Poly(arylen-1,3,4-oxadiazolen, Poly(p-phenylen)-Derivaten, Polythiophenen sowie Verbunden, Legierungen oder Blends hiervon und/oder einen Triplettemitter, insbesondere Iridiumkomplex aus niedermolekularen oder polymeren Elektronen- oder Lochleitern.

Für die Abscheidung mittels Spin-Coating wird der Emitter vorzugsweise zunächst in einem organischen Lösungsmittel, insbesondere Toluol, Xylol, Chlorbenzol oder Chloroform gelöst. Wird der Emitter mittels Ink-Jet-Druck abgeschieden, wird zusätzlich noch ein höher siedendes Lösungsmittel zur Erhöhung des Siedepunktes zugesetzt. Dieses ist vorzugsweise ausgewählt aus der Gruppe bestehend aus Dichlorbenzol, Trichlorbenzol oder Mesitylen.

Verwendung finden die strukturierten organischen Leuchtdioden als selbstleuchtende Sicherheitsbauelemente, insbesondere zum Nachweis und zur Kontrolle von Produkten.

Anhand der nachfolgenden Figur und Beispiele soll der erfindungsgemäße Gegenstand näher erläutert werden, ohne diesen auf die hier gezeigten speziellen Ausführungsformen einschränken zu wollen.

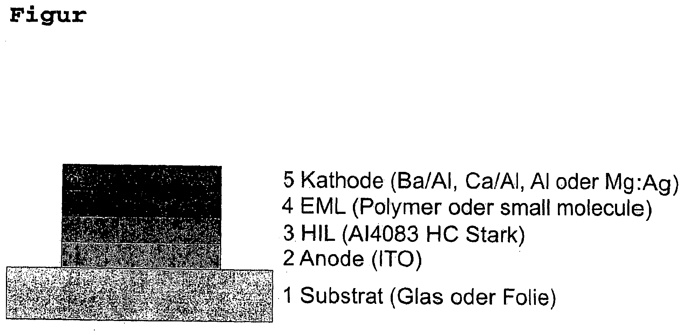

Die Figur zeigt schematisch den Aufbau einer strukturierten organischen Leuchtdiode, die in Beispiel 1 hergestellt wurde.

### Beispiel 1:

Bei der Herstellung der gezeigten OLEDs wird von einem Indium-Zinn-Oxid beschichtetem Glas mit einer Größe von 50x50 mm ausgegangen. Die aktive Fläche befindet sich im Zentrum des Substrates und ist in vier Segmente mit einer Fläche von je 0,85 cm² unterteilt. Die Substrate werden einem Reinigungsprozess unterzogen und anschließend mit dem Lochinjektionsmaterial AI4083 der Firma H.C. Starck homogen beschichtet. Die Beschichtung erfolgt durch Ink-Jet Druck oder durch spin-coating in einer Inertgasatmosphäre. Nach einem kurzen Trocknungsprozess bei 100 °C erfolgt der strukturierte Auftrag mittels Ink-Jet Druck. Das anschließende Ausheizen erfolgt bei 180 °C für 15 min. Die so vorbereiteten Substrate werden nun mittels spin-coating oder Ink-Jet Druck mit der emittierenden Schicht versehen. Nach einer weiteren Temperung bei 110 °C für 15 min wird die Kathode im Hochvakuum durch eine Schattenmaske aufgedampft. Der gesamte Aufbau, wie er in der Figur dargestellt ist, wird entweder durch flächige Verkapselung oder durch Randverkapselung mit integriertem Getter vor dem Zutritt von Sauerstoff und Wasser geschützt. Die so hergestellten Devices werden durch gleichzeitige Ansteuerung aller vier Segmente mit Spannungen von vier bis zehn Volt zum Leuchten gebracht.

### Beispiel 2:

Die Ausführung erfolgt analog zu Beispiel 1. Die Information wird jedoch in die emittierende Schicht eingeschrieben. Dabei kann der strukturierte Auftrag mit dem gleichen Material wie der flächige Auftrag erfolgen. Es kann jedoch auch ein Material mit einer anderen Emissionsfarbe verwendet werden, um so einen zusätzlichen Farbeffekt zu erzeugen.

### Beispiel 3:

Erfindungsgemäss wird die Information in die Lochinjektionsschicht und in die emittierende Schicht eingeschrieben. Durch die Überlagerung von zwei verschiedenen Motiven lassen sich zusätzliche Effekte erzeugen.

### Beispiel 4:

Die Aufbauten von Beispiel 1 bis 3 werden auf flexiblen Substraten (z.B. PET-Folie) appliziert. Hierbei ist nur eine Anpassung der Temperierungsschritte erforderlich. Ein solcher Aufbau kann in eine Chipkarte laminiert werden. Die Stromversorgung der OLED kann direkt über aufgebrachte Kontakte oder mit Hilfe eines RF-Transponders erfolgen. Die Ansteuerung über einen Transponder stellt hierbei eine zusätzliche Sicherheitsbarriere dar, da die Information nur mit speziellen Geräten ausgelesen werden kann.

## Patentansprüche

1. Verfahren zur Herstellung einer strukturierten organischen Leuchtdiode (OLED), bei dem
a) in einem ersten Schritt auf einem mit Indium-Zinnoxid beschichteten Träger eine Lochinjektionsschicht abgeschieden wird,
b) die Abscheidung mindestens einer Emitterschicht und einer Kathode erfolgt und
c) anschließend die OLED verkapselt wird,
bei der Abscheidung der Lochinjektionsschicht zunächst eine erste homogene Lochinjektionsschicht und anschließend eine zweite strukturierte Lochinjektionsschicht oder eine strukturierte Passivierungsschicht mittels Ink-Jet-Druck abgeschieden wird, **dadurch gekennzeichnet, dass** bei der Abscheidung der Emitterschicht in einem ersten Schritt auf der Lochinjektionsschicht oder der Passivierungsschicht eine homogene Emitterschicht mittels Spin-Coating oder Ink-Jet-Druck abgeschieden wird und anschließend in einem zweiten Schritt auf dieser homogenen Emitterschicht eine strukturierte Emitterschicht mittels Ink-Jet-Druck abgeschieden wird und
der Kontrast der Strukturierung über das Verhältnis der abgeschiedenen Mengen für die homogenen und die strukturierten Schichten eingestellt wird.

2. Verfahren nach einem der vorhergehenden Ansprüche,
**dadurch gekennzeichnet, dass** zwischen den Abscheideschritten die abgeschiedenen Schichten getrocknet werden, insbesondere bei Temperaturen im Bereich von 80 bis 180°C.

3. Verfahren nach einem der vorhergehenden Ansprüche,
**dadurch gekennzeichnet, dass** die Lochinjektionsschichten ein Lochinjektionsmaterial ausgewählt aus den Gruppen der wässrigen Dispersionen von Poly(3,4-ethylendioxythiophen)poly(styrensulfonat), Poly(thiophen-3-(2-(2-methoxyethoxy)ethoxy)-2,5-diyl (sulfoniert) oder Polyanilin enthalten.

4. Verfahren nach dem vorhergehenden Ansprüche,
**dadurch gekennzeichnet, dass** das Lochinjektionsmaterial aus einem wässrigen Lösungsmittelgemisch, insbesondere aus Wasser, Isopropanol, Ethylenglykol und einem Haftvermittler, abgeschieden wird.

5. Verfahren nach einem der vorhergehenden Ansprüche,
**dadurch gekennzeichnet, dass** die Emitterschicht als Emitter einen Singulettemitter, insbesondere ein konjugiertes Polymer ausgewählt aus der Gruppe bestehend aus substituierten Poly-(p-arylenvinylen)-Derivaten, Polyfluorenen, Polycarbazolen, Poly(arylen-1,3,4-oxadiazolen, Poly(p-phenylen)-Derivaten, Polythiophenen sowie Verbunde, Legierungen oder Blends hiervon und/oder einen Triplettemitter, insbesondere Iridiumkomplex aus niedermolekularen oder polymeren Elektronen- oder Lochleitern, enthält.

6. Verfahren nach einem der vorhergehenden Ansprüche,
**dadurch gekennzeichnet, dass** der Emitter für die Abscheidung mittels Spin-Coating zunächst in einem organischen Lösungsmittel, insbesondere Toluol, Xylol, Chlorbenzol oder Chloroform gelöst wird.

7. Verfahren nach einem der vorhergehenden Ansprüche,
**dadurch gekennzeichnet, dass** der Emitter für die Abscheidung mittels Ink-Jet-Druck zusätzlich ein Lösungsmittel zur Erhöhung des Siedepunktes, insbesondere ausgewählt aus der Gruppe bestehend aus Dichlorbenzol, Trichlorbenzol oder Mesitylen, zugesetzt wird.

## Claims

1. Method for the production of a structured, organic light-emitting diode (OLED), in which
a) in a first step, a hole injection layer is deposited on a carrier coated with indium-tin oxide,
b) the deposition of at least one emitter layer and one cathode is effected and
c) subsequently the OLED is encapsulated,
in the deposition of the hole injection layer, firstly a first homogeneous hole injection layer and subsequently a second structured hole injection layer or a structured passivation layer is deposited by means of inkjet printing, **characterized in that**
in the deposition of the emitter layer, in a first step a homogeneous emitter layer is deposited on the hole injection layer or on the passivation layer by means of spin-coating or inkjet printing and subsequently in a second step a structured emitter layer is deposited on this homogeneous emitter layer by means of inkjet printing, and
the contrast of the structuring is adjusted via the ratio of the deposited quantities for the homogeneous and the structured layers.

2. Method according to one of the preceding claims,
**characterised in that**, between the deposition steps, the deposited layers are dried, in particular at temperatures in the range of 80 to 180°C.

3. Method according to one of the preceding claims,
**characterised in that** the hole injection layers comprise a hole injection material selected from the groups of aqueous dispersions of poly(3,4-ethylene dioxythiophene)poly(styrene sulphonate), poly(thiophene-3-(2-(2-methoxyethoxy)ethoxy)-2,5-diyl (sulphonated) or polyaniline.

4. Method according to the preceding claim,
**characterised in that** the hole injection material is deposited from an aqueous solvent mixture, in particular from water, isopropanol, ethylene glycol and an adhesive.

5. Method according to one of the preceding claims,
**characterised in that** the emitter layer comprises, as emitter, a singlet emitter, in particular a conjugated polymer selected from the group consisting of substituted poly-(p-arylene vinylene) derivatives, polyfluorenes, polycarbazoles, poly(arylene-1,3,4-oxadiazoles, poly(p-phenylene) derivatives, polythiophenes and also composites, alloys or blends hereof and/or a triplet emitter, in particular iridium complex made of low-molecular or polymeric electron- or hole conductors.

6. Method according to one of the preceding claims,
**characterised in that**, for the deposition by means of spin-coating, the emitter is dissolved firstly in an organic solvent, in particular toluene, xylene, chlorobenzene or chloroform.

7. Method according to one of the preceding claims,
**characterised in that**, to the emitter for the deposition by means of inkjet printing, in addition a solvent is added in order to increase the boiling point, in particular selected from the group consisting of dichlorobenzene, trichlorobenzene or mesitylene.

## Revendications

1. Procédé de fabrication d'une diode électroluminescente organique (OLED) structurée, dans lequel
a) dans une première étape, on dépose une couche d'injection de trous sur un support revêtu d'un oxyde d'indium et d'étain,
b) on procède au dépôt d'au moins une couche émettrice et d'une cathode, et
c) puis on encapsule l'OLED,
lors du dépôt de la couche d'injection de trous, on dépose par impression au jet d'encre d'abord une première couche d'injection de trous homogène, puis une seconde couche d'injection de trous structurée ou une couche de passivation structurée, **caractérisé en ce que**
lors du dépôt de la couche émettrice, on dépose dans une première étape à la tournette ou par impression au jet d'encre une couche émettrice homogène sur la couche d'injection de trous ou sur la couche de passivation, puis, dans une deuxième étape, on dépose par impression au jet d'encre une couche émettrice structurée sur cette couche émettrice homogène, et
on ajuste le contraste de la structuration en agissant sur le rapport entre les quantités déposées pour la couche homogène et pour la couche structurée.

2. Procédé selon l'une des revendications précédentes, **caractérisé en ce qu'**entre les étapes de dépôt on sèche les couches déposées, en particulier à des températures comprises dans la plage de 80 à 180 °C.

3. Procédé selon l'une des revendications précédentes, **caractérisé en ce que** les couches d'injection de trous contiennent un matériau d'injection de trous choisi parmi les groupes des dispersions aqueuses de poly(3,4-éthylènedioxythiophéne)poly(styrènesulfonate), de poly(thiophène-3-(2-(2-méthoxyéthoxy)éthoxy)-2,5-diyle)(sulfoné) ou de polyaniline.

4. Procédé selon la revendication précédente, **caractérisé en ce que** le matériau d'injection de trous est déposé à partir d'un mélange de solvants aqueux, en particulier un mélange d'eau, d'isopropanol, d'éthylèneglycol, et d'un promoteur d'adhérence.

5. Procédé selon l'une des revendications précédentes, **caractérisé en ce que** la couche émettrice contient en tant qu'émetteur un émetteur de singulets, en particulier un polymère conjugué choisi dans le groupe consistant en les dérivés de poly(p-arylènevinylène) substitués, les polyfluorènes, les polycarbazoles, les poly(arylène-1,3,4-oxadiazoles), les dérivés de poly(p-phénylène), les polythiophènes, ainsi que les composites, alliages ou mélanges de ceux-ci, et/ou un émetteur de triplets, en particulier un complexe d'iridium constitué de conducteurs d'électrons ou de trous, à faible masse moléculaire ou polymères.

6. Procédé selon l'une des revendications précédentes, **caractérisé en ce que** l'émetteur est, pour le dépôt à la tournette, dissous d'abord dans un solvant organique, en particulier le toluène, le xylène, le chlorobenzène ou le chloroforme.

7. Procédé selon l'une des revendications précédentes, **caractérisé en ce qu'**on ajoute en outre à l'émetteur pour le dépôt par impression au jet d'encre un solvant pour élever le point d'ébullition, choisi en particulier dans le groupe consistant en le dichlorobenzène, le trichlorobenzène ou le mésitylène.
